# EUROPÄISCHE PATENTSCHRIFT

(11) **EP 0 552 642 B1**
(45) Veröffentlichungstag und Bekanntmachung des Hinweises auf die Patenterteilung: **04.09.1996**
(21) Anmeldenummer: 93100319.8
(22) Anmeldetag: 12.01.1993
(51) Int. Cl.: H04B 1/54, H03C 3/09, H03D 3/24

(54) **Kombiniertes Funksende- und -empfangsgerät mit einer PLL-Schaltung**
Combined radio transmitter and receiver with PLL circuit
Radioémetteur et -récepteur avec circuit à bande de verrouillage de phase

(30) Priorität: 21.01.1992 DE 4201415
(43) Veröffentlichungstag der Anmeldung: 28.07.1993
(73) Patentinhaber: TEMIC TELEFUNKEN microelectronic GmbH, 74072 Heilbronn (DE)
(72) Erfinder: Boese, Ingo, W-5900 Siegen (DE); Gebauer, Volker, W-6095 Ginsheim-Gustavsburg 1 (DE)
(74) Vertreter: Maute, Hans-Jürgen, Dipl.-Ing.

(56) Entgegenhaltungen:
- EP-A- 0 322 139
- WO-A-89/07865
- US-A- 4 520 476
- PATENT ABSTRACTS OF JAPAN vol. 6, no. 170 (E-128)31. Mai 1982
- PATENT ABSTRACTS OF JAPAN vol. 9, no. 027 (E-294)27. September 1984

## Beschreibung

Die Erfindung betrifft ein Funksende- und -empfangsgerät nach dem Oberbegriff des Anspruchs 1.

Funksende- und -empfangsgeräte, in denen Sende- und Empfangsteil über je eine PLL-Schaltung zur Signalmodulation und -demodulation verfügen oder nur Empfangs- bzw. Sendeteil mit einer PLL-Schaltung ausgestattet sind, sind Stand der Technik und z. B. aus R. Best: "Theorie und Anwendung des Phase-locked Loops", AT-Verlag, 1987, insbesondere Seiten 87-91, bekannt. Bei den erstgenannten Schaltungen ist als Nachteil der hohe Bedarf an den Bauteilen und somit die hohen Herstellungskosten anzuführen. Bei den letztgenannten Schaltungen wird entweder im Sende- oder im Empfangsteil auf die Vorzüge der PLL-gesteuerten Modulationen bzw. Demodulationen verzichtet.

Aus der JP 57 08 72 12 ist ein FM-Modulator und -Demodulator bekannt, bei dem eine PLL-Schaltung durch Umschalten sowohl zur Modulation als auch zur Demodulation verwendet wird. Das zu demodulierende Signal wird auf den ersten Eingang eines Phasendetektors gegeben. Dessen zweiter Eingang ist mit dem spannungsgesteuerten Oszillator VCO der Rückkoppelschleife verbunden. Am Ausgang des Phasendetektors wird nach einer Filterstufe das demodulierte Ausgangssignal bereitgestellt. Dieses dient gleichzeitig als Steuersignal für den VCO der Rückkoppelschleife. Zur Modulation wird dem Eingang des VCOs das zu modulierende Signal zugeführt. Der erste Eingang des Phasendetektors ist dann mit einem Referenzoszillator verbunden und in der Rückkoppelschleife ist ein zusätzlicher Frequenzteiler eingeschaltet. Das modulierte Ausgangssignal wird am Ausgang des VCOs entnommen.

Aus der JP 59 17 13 34 ist eine Radioausrüstung bekannt, bei der die Signalmodulation bzw. -demodulation ebenfalls durch wechselseitigen Zugriff auf eine PLL-Schaltung erfolgt. Im Unterschied zu dem zuvor genannten FM-Modulator und -Demodulator erfolgt die Signalmodulation durch ein Verstimmen bzw. Verziehen des Referenzoszillators.

Aus der WO 89 07 865 ist ein Funksende- und -empfangsgerät bekannt, bei dem die Signalmodulation durch eine PLL-Schaltung durch Modulieren der Eingangsspannung des VCO erfolgt. Weiterhin können die unterschiedlichen Kanäle durch Ändern des Teilerverhältnisses im Rückkopplungszweig der PLL-Schaltung ausgewählt werden.

Aus der EP 0 322 139 ist eine Schaltungsanordnung zur Frequenz- oder Phasenmodulation bekannt, bei der das Teilerverhältnis im Rückkoppelzweig der PLL-Schaltung verändert wird.

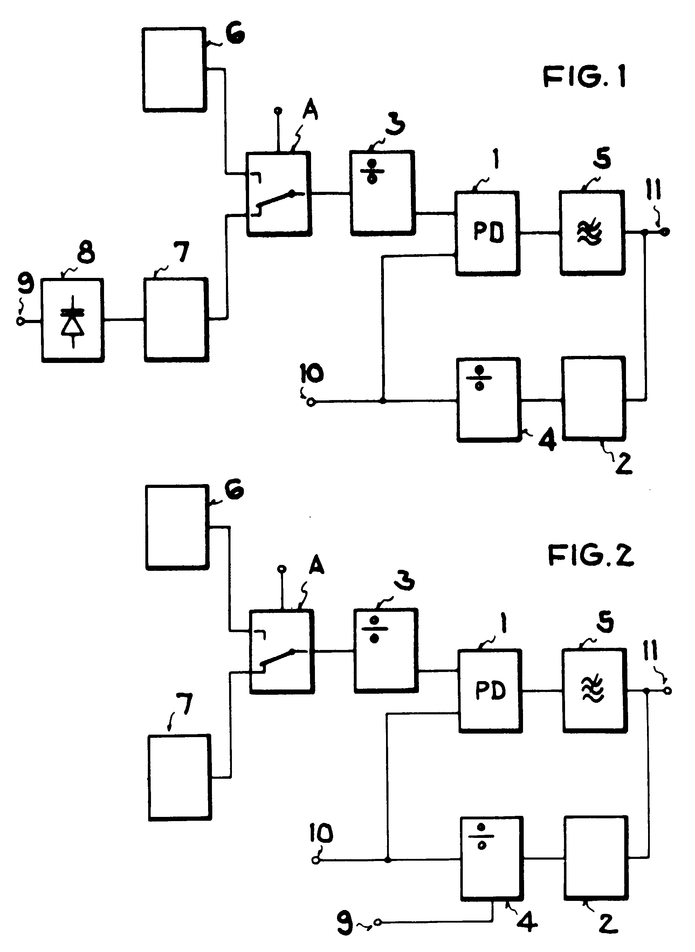

Die Figuren 1 und 2 zeigen je eine Ausführungsform des Standes der Technik. Die beiden Schaltungen unterscheiden sich in der Art, wie die Modulation des Signals erfolgt. Zunächst werden jedoch die Gemeinsamkeiten der beiden Schaltungen beschrieben. Abhängig von der Schalterstellung A wird einem ersten Eingang des Phasendetektors 1 über einen ersten Frequenzteiler 3 entweder das Signal einer HF-Eingangsschaltung 6 oder das Signal eines Referenzoszillators 7 zugeführt. Der Referenzoszillator kann aus einem RC-Schwingkreis, einem VCO oder vorzugsweise einem Quarzoszillator bestehen. Das Ausgangssignal des Phasendetektors 1 wird über einen Loop-Filter 5 einem ersten VCO 2 zu dessen Steuerung zugeführt. Das Ausgangssignal des ersten VCOs 2 wird über einen zweiten Frequenzteiler 4 dem zweiten Eingang des Phasendetektors 1 zugeführt. Der Phasendetektor 1 bildet zusammen mit dem ersten VCO 2, dem ersten und zweiten Frequenzteiler 3, 4 und dem Loop-Filter 5 eine PLL-Schaltung wie sie dem Fachmann hinlänglich bekannt ist. Diese PLL-Schaltung ist den jeweiligen Anforderungen des Funksende- und -empfangsgeräts anzupassen. Dies kann mit Hilfe der Teilerverhältnisse der beiden Frequenzteiler 3, 4, der Mittenfrequenz des VCOs oder z. B. der Eigenschaften des Loop-Filters 5 geschehen. Mit Hilfe des Schalters A kann die PLL-Schaltung nun entweder in einen Sende- oder Empfangszustand versetzt werden. In der Schalterstellung, wie sie in den Figuren 1 und 2 eingezeichnet ist, sind die beiden PLL-Schaltungen im Sendezustand. Der Phasendetektor 1 ist mit seinem ersten Eingang über den ersten Frequenzteiler 3 mit dem Referenzoszillator 7 verbunden. In der Schaltung nach Figur 1 wird die Frequenz des Referenzoszillators 7 z. B. mit Hilfe einer Kapazitätsdiode 8 in Abhängigkeit vom am Dateneingang 9 anliegenden Datensignal verändert. Die PLL-Schaltung folgt diesem Signal und regelt den im Rückkoppelzweig befindlichen ersten VCO 2 nach. Im allgemeinen wird das so erhaltene, modulierte Signal zunächst nochmals in einem zweiten Frequenzteiler 4 heruntergeteilt und dann dem zweiten Eingang des Phasendetektors zugeführt. Am Ausgang des zweiten Frequenzteilers 4 kann das modulierte Ausgangssignal 10 zur weiteren Verarbeitung in einem HF-Ausgangsteil abgegriffen werden.

In der Schaltung nach Figur 2 ist der erste Eingang des Phasendetektors 1 mit einem fest abgestimmten Referenzoszillator 7 verbunden. Die Modulation der Schwingung mit dem Datensignal erfolgt im Gegensatz zur Schaltung nach der Figur 1 durch eine Änderung des Teilerverhältnisses des zweiten Frequenzteilers 4 innerhalb der Rückkoppelschleife der PLL-Schaltung. Das Teilerverhältnis des zweiten Frequenzteilers 4 wird in Abhängigkeit von dem am Dateneingang 9 anliegenden Signal verändert und die PLL-Schaltung somit in ihrer Frequenz gezogen. Die PLL-Schaltung versucht nun die am Phasendetektor 1 entstehende Phasendifferenz durch entsprechende Ansteuerung des ersten VCOs 2 auszugleichen. Dabei entsteht am Ausgang des VCOs eine mit dem Datensignal frequenzmodulierte Schwingung. Ebenso wie bei der Schaltung nach Figur 1 erfolgt das Auskoppeln des modulierten Ausgangssignals 10 am Verbindungspunkt des zweiten Eingangs des Phasendetektors 1 mit dem zweiten Frequenzteiler 4. Beide Modulationsarten sind als Frequency Shift Keying (FSK) bekannt.

Der Empfangszustand der beiden Schaltungen nach Figur 1 und Figur 2 wird durch Umschaltung der in den Figuren eingezeichneten Schalterstellung A erreicht. Dann ist der Phasendetektor 1 über den ersten Frequenzteiler mit dem HF-Eingangsteil des Funksende- und -empfangsgeräts verbunden. Der Phasendetektor 1 bildet mit dem im Rückkoppelzweig angeordneten ersten VCO 2 einen Phase-locked Loop. Am Ausgang des Loop-Filters 5 kann das demodulierte Eingangssignal zur weiteren Signalverarbeitung abgegriffen werden.

Bei den Schaltungen nach den Figuren 1 und 2 ergibt sich prinzipiell das Problem, daß bei den auf dem Markt erhältlichen ICs für PLL-Schaltungen, diese beinhalten im wesentlichen die Frequenzteiler und den Phasendetektor, die Eingänge für den Referenzoszillator bzw. HF-Teil relativ niedrige Grenzfrequenzen aufweisen und somit für das erfindungsgemäße, kombinierte Sende- und Empfangskonzept mit höheren Sendefrequenzen im VHF- und UHF-Frequenzbereich nicht geeignet sind.

Aufgabe der Erfindung ist es daher, ein Funksende- und -empfangsgerät anzugeben, das eine gemeinsame PLL-Schaltung im Sende- und Empfangsteil des Geräts verwendet und die genannten Nachteile vermeidet. Diese Aufgabe wird gelöst durch ein Funksende- und -empfangsgerät mit den kennzeichnenden Merkmalen des Anspruchs 1.
Ein Hauptvorteil der Erfindung liegt darin, daß bei einem kombinierten Funksende- und -empfangsgerät nach der Erfindung ein großer Teil der Bauteile des Phase-locked Loop sowohl zur Signalmodulation beim Senden als auch zur Signaldemodulation beim Empfang verwendet wird. Diese gemeinsame Verwendung eines Schaltungsteils für Sende- und Empfangsteil ist besonders vorteilhaft insbesondere bei Funksende- und -empfangsgeräten einzusetzen, bei denen die Datenübertragung bidirektional im Zeitmultiplexbetrieb erfolgt. Sende- und Empfangsaufgaben werden hierbei von der Schaltung nicht gleichzeitig, sondern im zeitversetzten Wechsel wahrgenommen. Das Funksende- und -empfangsgerät kann durch einfache Umschaltmaßnahmen in einen Sendezustand oder einen Empfangszustand versetzt werden. Die vorteilhafte Ausgestaltung der Erfindung ergibt sich aus den Unteransprüchen.

Im folgenden sei die Erfindung anhand der Figuren erläutert. Es zeigen:
- Figur 1:: eine erste Ausführungsform des Standes der Technik.
- Figur 2:: eine zweite Ausführungsform des Standes der Technik
- Figur 3:: eine erste Ausführungsform der Erfindung zu der ersten Modulationsart.
- Figur 4:: eine zweite Ausführung der Erfindung zu der zweiten Modulationsart.
- Figur 5:: ein Funksende- und -empfangsgerät nach einer Schaltung gemäß Figur 3.
- Figur 6:: ein umschaltbarer Referenzoszillator/VCO.

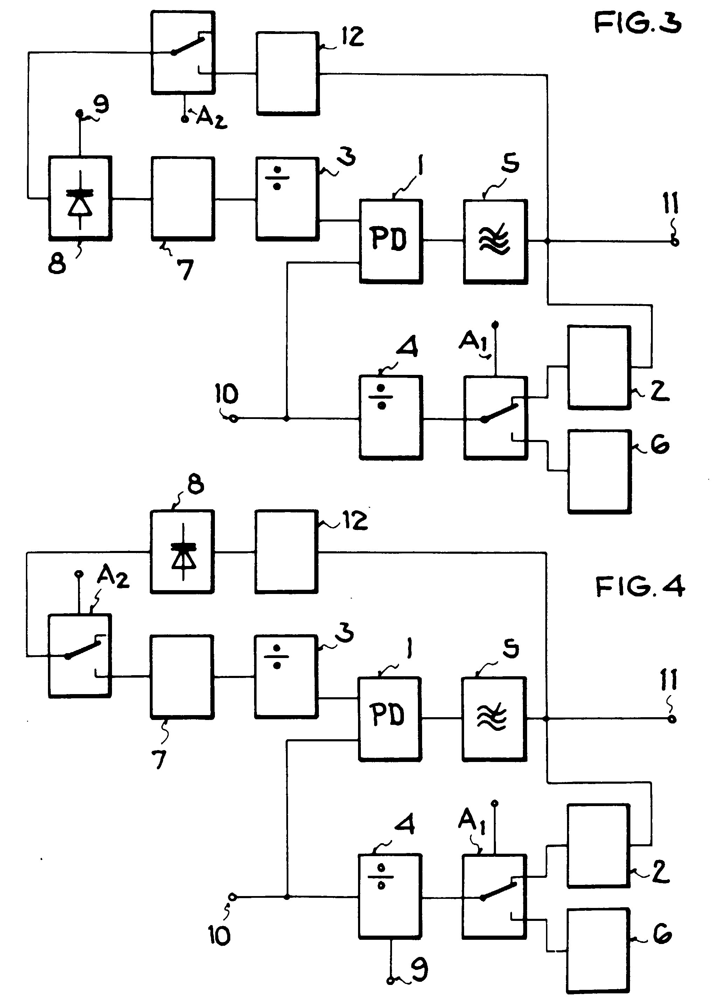

Bei den Funksende- und -empfangsgeräten nach den Figuren 3 und 4 werden beim Umschalten vom Sende- in den Empfangszustand Rückkoppelschleife und Referenzeingang miteinander vertauscht. Im Sendezustand sind die Schalter A1 und A2, in der in den Figuren 3 und 4 eingezeichneten Stellung. Mit dem ersten Eingang des Phasendetektors 1 ist ein Referenzoszillator 7 verbunden. Das Ausgangssignal des Referenzoszillators 7 wird im allgemeinen zunächst über eine erste Frequenzteilerstufe 3 geführt und entsprechend dem Teilerverhältnis in der Frequenz herabgesetzt. Das Ausgangssignal des Phasendetektors 1 wird einer Loop-Filterstufe 5 und anschließend dem VCO 2 zur Schwingungssteuerung zugeführt. Über den Schalter A1 und eine zweite Frequenzteilerstufe 4 gelangt das Ausgangssignal des VCO 2 zum zweiten Eingang des Phasendetektors 1.

Bei der Anordnung nach der Figur 3 wird eine Modulation des Schwingungszustandes des Phase-locked Loop durch ein Verstimmen des Referenzoszillators 7 z. B. mit einer Kapazitätsdiode 8 erreicht. Dazu wird der Kapazitätsdiode 8 ein entsprechend aufbereitetes Datensignal am Dateneingang 9 zugeführt.

Bei der Anordnung nach Figur 4 wird die Modulation des Schwingungszustandes des Phase-locked Loop durch eine Änderung des Teilerverhältnisses der zweiten Frequenzteilerstufe 4 innerhalb des Rückkoppelzweiges analog zu einem Datensignal erreicht. Dazu wird der zweiten Frequenzteilerstufe 4 am Dateneingang 9 ein zum Datensignal proportionales Teilerverhältnis zugeführt.

In beiden Fällen kann das modulierte Ausgangssignal am Datenausgang 10 am zweiten Eingang des Phasendetektors abgegriffen werden.

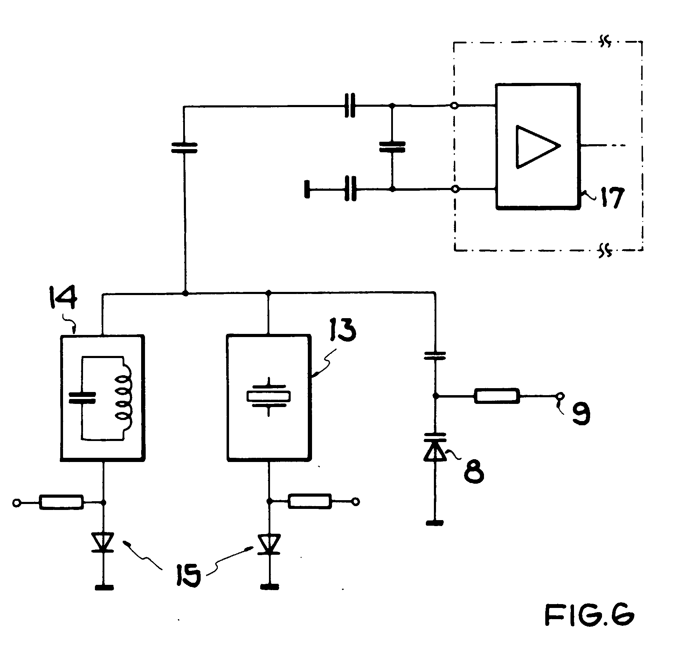

Im Empfangsfall sind die in den Figuren eingezeichneten Schalterstellungen umzukehren. Dann wird dem Phasendetektor 1 am zweiten Eingang über die zweite Frequenzteilerstufe 4 das Ausgangssignal der HF-Eingangsschaltung 6 zugeführt. Die Rückkoppelschleife des Phase-locked Loops wird vom Ausgang des Phasendetektors 1 über das Loop-Filter 5, den Referenzoszillator 7 und die erste Frequenzteilerstufe 3 zurück zum ersten Eingang des Phasendetektors 1 geführt. Am Ausgang der Loop-Filterstufe 5 befindet sich der Datenausgang 11 des Funksende- und -empfangsgeräts. Von dort aus kann das demodulierte Empfangssignal der weiteren Signalverarbeitung zugeführt werden. Der Referenzoszillator 7 hat in dieser Ausgestaltung der Erfindung nicht nur eine quarzgenaue Referenzschwingung zur Verfügung zu stellen. Im Empfangszustand der Schaltung arbeitet der Referenzoszillator als spannungsgesteuerter Oszillator, kurz VCO. Das ist in den Figuren 3 und 4 durch die Kapazitätsdiode 8 dargestellt. Durch geeignete Maßnahmen muß das Schwingungsverhalten des Referenzoszillators 7 proportional zur Ausgangsspannung des Phasendetektors 1 gesteuert werden. Dies kann beispielsweise durch einen Referenzoszillator erzielt werden, wie er in der Figur 6 dargestellt ist.

Je nach Steuerung des Referenzoszillators 7 durch die Kapazitätsdiode 8 kann es notwendig werden, einen Inverter 12 in die Rückkoppelschleife des Empfangszustandes einzuführen. Da sich durch das Vertauschen von Referenzoszillator 7 und VCO 2 an den beiden Eingängen des Phasendetektors 1 beim Umschalten vom Sende- in den Empfangszustand das Vorzeichen der Phasendifferenz ändert, ist es notwendig das Vorzeichen der Regelspannung entsprechend zu korrigieren. Das kann in vorteilhafter Weise durch den Inverter 12 geschehen, der in die Rückkoppelschleife eingefügt ist und das Vorzeichen der Regelspannung umkehrt.

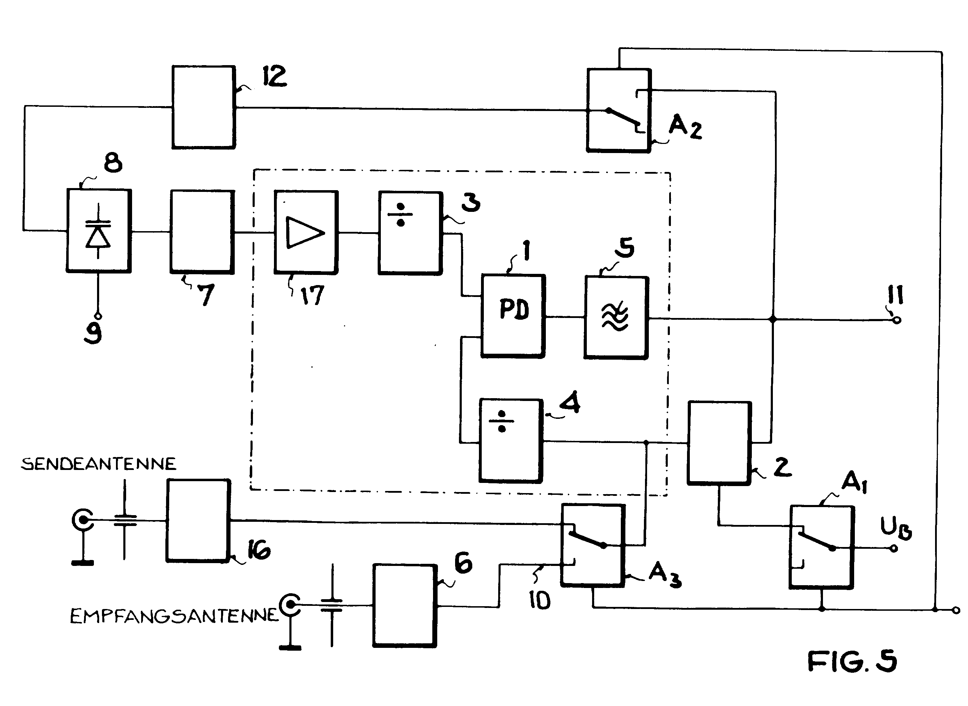

Die Figur 5 zeigt eine weitere vorteilhafte Ausgestaltung eines erfindungsgemäßen Funksende- und -empfangsgeräts. Diese Ausführung ist vom Arbeitsprinzip her aufgebaut wie die Ausführung nach der Figur 3. Kernstück ist der Phasendetektor 1. Der Ausgang des Phasendetektors 1 ist über den Loop-Filter 5 mit dem ersten VCO 2 verbunden. Wenn der erste VCO 2 durch den Schalter A1 mit der Betriebsspannung U_{B} verbunden ist, so arbeitet der erste VCO 2 und die Rückkoppelschleife des Phase-locked Loops ist über den VCO und die zweite Frequenzteilerstufe 4 zum zweiten Eingang des Phasendetektors 1 geschlossen. Da der Schalter A2 im Sendezustand offen ist, arbeitet der zweite Oszillator 7 als Referenzoszillator. Der zweite Oszillator 7 ist über ein aktives Element 17 und eine erste Frequenzteilerstufe 3 mit dem ersten Eingang des Phasendetektors 1 verbunden. Mittels einer Kapazitätsdiode 8 wird der als Referenzoszillator arbeitende, zweite Oszillator 7 proportional zu dem am Dateneingang 9 anliegenden Datensignal um seine Mittenfrequenz verstimmt. Der Phase-locked Loop folgt dieser Verstimmung, so daß über den Schalter A3 das modulierte Ausgangssignal der HF-Ausgangsstufe 16 zugeführt wird. Die HF-Ausgangsstufe speist das Signal in die Sendeantenne ein.

Im Empfangszustand sind alle, in der Figur 5 eingezeichneten Schalterstellungen der Schalter A1 bis A3 umzukehren. Der Schalter A1 unterbricht die Spannungsversorgung des ersten VCO 2, so daß an dieser Stelle der Rückkoppelzweig des Phase-locked Loop unterbrochen ist. Statt dessen wird dem zweiten Eingang des Phasendetektors 1 über die zweite Frequenzteilerstufe 4 und den Schalter A3 das von der HF-Eingangsstufe 6 vorverarbeitete Empfangssignal zugeführt. Das Funksende- und -empfangsgerät kann dabei so ausgebildet sein, daß Senden und Empfangen der Signale über eine gemeinsame Antenne erfolgt. In der vorteilhaften Ausgestaltung nach der Figur 5 sind jedoch getrennte Sende- und Empfangsantennen vorgesehen. Dem zweiten Eingang des Phasendetektors 1 wird im Empfangszustand als Referenzsignal das Eingangssignal des Empfangsteils zugeführt. Der Rückkoppelzweig des Phase-locked Loops wird nun gebildet vom Loop-Filter 5, dem im Empfangszustand geschlossenen Schalter A2 und dem als steuerbaren Oszillator arbeitenden zweiten Oszillator 7. Der zweite Oszillator 7 ist in seiner Funktion umschaltbar zwischen quarzgenauem Referenzoszillator und spannungsgesteuertem VCO und kann z. B. nach der Figur 6 aufgebaut sein. Die Ansteuerung des Oszillators erfolgt über einen Inverter 12 und eine Kapazitätsdiode 8. Da der Oszillator 7 über ein aktives Element 17 und die erste Frequenzteilerstufe 3 mit dem ersten Eingang des Phasendetektors 1 verbunden ist, ist der Rückkoppelzweig des Phase-locked Loops im Empfangsfall über diesen Zweig der Schaltung geschlossen. Das demodulierte Signal kann am Ausgang des Loop-Filters 5 entnommen und der weiteren Signalverarbeitung zugeführt werden. Mit einer strichpunktierten Linie sind in der Figur 5 alle Schaltungsblöcke zusammengefaßt, die im allgemeinen auf einem kommerziell erhältlichen PLL-IC enthalten sind. Diese Schaltungsblöcke werden nach der Erfindung sowohl im Sende- als auch im Empfangszustand des Funksende- und -empfangsgeräts wechselseitig angesprochen. Durch diese Doppelverwendung kann auf einen weiteren derartigen PLL-Schaltkreis verzichtet werden.

In der Figur 6 ist eine Oszillatorschaltung dargestellt, die sowohl als quarzstabiler Referenzoszillator als auch als spannungsgesteuerter Oszillator VCO arbeiten kann. Die Umschaltung zwischen den beiden Arbeitsweisen erfolgt durch wechselseitiges Durchschalten der beiden Schaltdioden 15. Am Steuerspannungseingang 9 kann der RC-Schwingkreis 14 des Oszillators in der Betriebsweise als VCO über die Kapazitätsdiode 8 in einem weiten Bereich gesteuert werden. In der Betriebsart als quarzstabiler Referenzoszillator kann die Schwingung des Referenzquarzes 13 nur in einem schmalen Bereich um seine Mittenfrequenz verstimmt werden. Über ein Kapazitätsnetzwerk sind die Oszillatoren mit einem meist im PLL-IC enthaltenen aktiven Element 17 verbunden. Ein derartig kombinierter Oszillator eignet sich besonders als umschaltbarer Oszillator in einer der Schaltungsanordnungen nach den Figuren 3 bis 5. Die Umschaltung des Oszillators erfolgt zusammen mit der Umschaltung der Schalter A1 bis A3.

Ein derartiges Funksende- und -empfangsgerät eignet sich insbesondere für den Einsatz bei Funkfernsteuerungseinrichtungen, die für einen bidirektionalen, zeitversetzten Sende- und Empfangsbetrieb ausgelegt sind. Aufgrund der platzsparenden Gesamtschaltung, wobei Sende- und Empfangsteil unter Ausnutzung desselben Phase-locked Loops zu einer Einheit vereinigt sind, ergeben sich kleinen Größen für die Handfunkfernbedienungen.

## Patentansprüche

1. Funksende- und -empfangsgerät mit einem Sende- und einem Empfangsteil und einer gemeinsamen PLL-Schaltung zur Signalmodulation bzw. Signaldemodulation, wobei die gemeinsame PLL-Schaltung aus einem Phasendetektor (1), einem ersten VCO (2) und einem Referenzoszillator (7) besteht, und im Sendezustand die Rückkoppelschleife der PLL-Schaltung über den ersten VCO (2) geschlossen ist, wobei im Empfangszustand die Rückkoppelschleife der PLL-Schaltung über den als spannungsgesteuerten Oszillator betriebenen Referenzoszillator (7) geschlossen ist und der Phasendetektor (1) mit dem Ausgang einer HF-Eingangsstufe (6) verbunden ist.

2. Funksende- und -empfangsgerät nach Anspruch 1, dadurch gekennzeichnet, daß die Signalmodulation im Sendezustand durch ein Verstimmen des als Referenzoszillator arbeitenden weiteren Oszillators (7) erfolgt.

3. Funksende- und -empfangsgerät nach Anspruch 1, dadurch gekennzeichnet, daß die Signalmodulation im Sendezustand durch ein Ändern des Teilerverhältnisses einer im Rückkoppelzweig der PLL-Schaltung angeordneten Frequenzteilerstufe (4) erfolgt.

4. Funksende- und -empfangsgerät nach einem der Ansprüche 1 bis 3, dadurch gekennzeichnet, daß das Senden und Empfangen eines Signals über eine Antenne erfolgt.

5. Funksende- und -empfangsgerät nach einem der Ansprüche 1 bis 3, dadurch gekennzeichnet, daß eine Sende- und eine Empfangsantenne vorgesehen ist, und daß die Umschaltung durch einen weiteren Schalter (A3) erfolgt.

6. Funksende- und -empfangsgerät nach einem der Ansprüche 1 bis 5, dadurch gekennzeichnet, daß sämtliche Schalter zur Umschaltung vom Sende- zum Empfangszustand von einem Umschaltsignal angesteuert werden.

## Claims

1. A radio transmitting and receiving device with a transmitting stage and a receiving stage and a common PLL circuit for the signal modulation and signal demodulation wherein the common PLL circuit consists of a phase detector (1), a first VCO (2) and a reference oscillator (7) and in the transmitting stage the feedback loop of the PLL circuit is closed via the first VCO (2), wherein in the receiving state the feedback loop of the PLL circuit is closed via the reference oscillator (7) operated as voltage-controlled oscillator and the phase detector (1) is connected to the output of a HF input stage (6).

2. A radio transmitting and receiving device as claimed in Claim 1, characterised in that the signal modulation in the transmitting state takes place by detuning of the further oscillator (7) operating as reference oscillator.

3. A radio transmitting and receiving device as claimed in Claim 1, characterised in that the signal modulation in the transmitting state takes place by changing the divider ratio of a frequency divider stage (4) arranged in the feedback arm of the PLL circuit.

4. A radio transmitting and receiving device as claimed in one of Claims 1 to 3, characterised in that the transmission and reception of a signal takes place via an antenna.

5. A radio transmitting and receiving device as claimed in one of Claims 1 to 3, characterised in that a transmitting antenna and a receiving antenna are provided and the switch-over is effected by a further switch (A3).

6. A radio transmitting and receiving device as claimed in one of Claims 1 to 5, characterised in that all the switches are actuated by a switch-over signal for switching over from the transmitting state to the receiving state.

## Revendications

1. Radioémetteur et -récepteur équipé d'une partie réception et d'un circuit à boucle de verrouillage de phase commun en vue d'une modulation de signal ou d'une démodulation de signal, le circuit à boucle de verrouillage de phase commun se composant d'un détecteur de phase (1), d'un premier VCO (2) et d'un oscillateur de référence (7), et dans l'état émission, la boucle de rétroaction du circuit de boucle à verrouillage de phase étant fermée par l'intermédiaire du premier VCO (2), dans l'état réception, la boucle de rétroaction du circuit de boucle à verrouillage de phase étant fermée par l'intermédiaire de l'oscillateur de référence (7) fonctionnant en tant qu'oscillateur commandé par tension et le détecteur de phase (1) étant relié à la sortie d'un étage d'entrée HF (6).

2. Radioémetteur et -récepteur selon la revendication 1, caractérisé en ce que la modulation du signal à l'émission s'effectue par un désaccord de l'autre oscillateur (7) fonctionnant en tant qu'oscillateur de référence.

3. Radioémetteur et -récepteur selon la revendication 1, caractérisé en ce que la modulation de signal à l'émission s'effectue par variation du rapport de division d'un étage diviseur de fréquence (4) disposé dans la branche de rétroaction du circuit de boucle à verrouillage de phase.

4. Radioémetteur et -récepteur selon l'une des revendications 1 à 3, caractérisé en ce que l'émission et la réception d'un signal s'effectue par l'intermédiaire d'une antenne.

5. Radioémetteur et -récepteur selon l'une des revendications 1 à 3, caractérisé en ce qu'une antenne d'émission et une antenne de réception sont prévues, et en ce que la commutation s'effectue par l'intermédiaire d'un autre commutateur (A3).

6. Radioémetteur et -récepteur selon l'une des revendications 1 à 5, caractérisé en ce que la totalité des commutateurs sont commandés en vue de la commutation de l'émission à la réception par un signal de commutation.
